# EUROPEAN PATENT APPLICATION

(11) **EP 4 640 860 A1**
(43) Date of publication of application: **29.10.2025**
(21) Application number: 23907661.5
(22) Date of filing: 18.12.2023
(51) Int. Cl.: C22C 24/00, C22C 12/00, C22C 1/02, C23C 16/06, H01L 33/44, B22D 21/00, H10K 50/81, H10K 50/82, H10K 50/16, H10K 50/17

(54) **LITHIUM ALLOY FOR VACUUM DEPOSITION, METHOD FOR MANUFACTURING LITHIUM ALLOY FOR VACUUM DEPOSITION, METHOD FOR MANUFACTURING LITHIUM THIN FILM FOR PHOTOELECTRIC DEVICE, AND PHOTOELECTRIC DEVICE CONTAINING LITHIUM THIN FILM PRODUCED THEREBY**

(30) Priority: 20.12.2022 KR 20220179726; 15.12.2023 KR 20230183203
(71) Applicant: FM Co., Ltd., Incheon 21688 (KR); Samsung Display Co., Ltd., Yongin-si, Gyeonggi-do 17113 (KR)
(72) Inventor: SUNG, Suk Ki, Seoul 05501 (KR); LEE, Jai Joon, Seoul 05507 (KR); KIM, Jun Hee, Wonju-si, Gangwon-do 26352 (KR); KHO, Young Joon, Suwon-si, Gyeonggi-do 16547 (KR); LEE, Hui Jung, Wonju-si, Gangwon-do 26367 (KR); KIM, Seok, Wonju-si, Gangwon-do 26346 (KR); KIM, Dong Chan, Yongin-si, Gyeonggi-do 17113 (KR)
(74) Representative: Marks & Clerk LLP
(86) International application number: PCT/KR2023/020898
(87) International publication number: WO 2024/136376

(57) **Abstract**

The present invention provides: a lithium alloy for vacuum deposition, the lithium alloy comprising 23 wt% to 91 wt% (exclusive of 23 wt% and 91 wt%) of bismuth (Bi), with the balance being lithium (Li) and other inevitable impurities, and including at least a Li₃Bi phase and a lithium phase; a method for manufacturing the lithium alloy for vacuum deposition; a method for manufacturing a lithium thin film for a photoelectric device; and a photoelectric device containing the lithium thin film produced thereby.

## Description

### TECHNICAL FIELD

The present invention relates to a lithium alloy for vacuum deposition, a method for manufacturing the lithium alloy for vacuum deposition, a method for manufacturing a lithium thin film for photoelectric devices, and a photoelectric device including the lithium thin film manufactured thereby.

### BACKGROUND ART

A photoelectric device generally refers to a device that converts light energy into electrical energy or electrical energy into light energy. Examples of such photoelectric devices include Organic Light Emitting Diodes (OLEDs), solar cells, and transistors. It has been reported that when lithium (Li) is added to the Charge Generation Layer (CGL) or the Electron Injection Layer (EIL) of photoelectric devices with a tandem structure, such as OLEDs, enhanced light emission characteristics can be achieved even at low current densities, thereby extending the lifespan of the device.

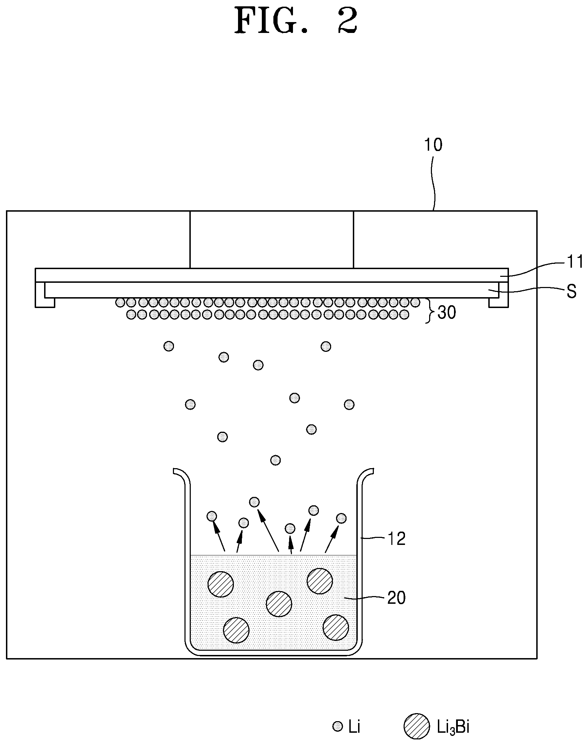

The lithium thin film used in photoelectric devices can be formed by a thermal vacuum deposition method. FIG. 2 illustrates a thermal vacuum deposition apparatus for forming a lithium thin film for photoelectric devices.

Referring to FIG. 2, the thermal vacuum deposition apparatus includes a vacuum deposition chamber 10 in which the thermal vacuum deposition is performed. The interior of the vacuum deposition chamber 10 is maintained in a vacuum state by using a vacuum pump (not shown). Inside the vacuum deposition chamber 10, an evaporation source container 12 and a substrate holder 11 are arranged. The evaporation source container 12 accommodates the evaporation source 20, and the substrate holder 11 is mounted with a substrate S on which the lithium thin film 30 is formed.

The evaporation source 20 is heated by various heat sources inside the evaporation source container 12, melted, and then evaporated into a gaseous state. The evaporated lithium is deposited onto one surface of the substrate S, thereby forming the lithium thin film 30 on that surface.

When pure lithium metal Li metal is used as the evaporation source in the thermal vacuum deposition method, its high reactivity significantly increases the risk of explosion or ignition during storage or preheating for deposition, thereby raising its hazardous material handling grade. Furthermore, the thermal vacuum deposition apparatus needs to be manufactured as an explosion-proof type, resulting in a substantial increase in manufacturing costs.

In the case of pure lithium, when exposed to the atmosphere during the preparation process for deposition, rapid oxidation or nitridation occurs on the surface, forming a thick surface film composed of compounds such as Li2O, LiOH, and Li3N. The Li3N (lithium nitride) formed on the lithium surface can react with moisture to generate ammonia gas and convert into LiOH (lithium hydroxide). LiOH and Li2O (lithium oxide) formed on the surface have high melting points of 462°C and 1438°C, respectively, making them unsuitable as evaporation sources for lithium. Therefore, if most of the surface is oxidized or nitrided, it becomes extremely difficult to vaporize and deposit the pure lithium present beneath the surface. Although it is possible to perform lithium deposition by setting the heating temperature for melting and evaporating lithium to 500°C or higher, increasing the heating temperature of lithium results in the degradation of the characteristics of the electronic device, making its application impractical.

To solve these issues, the surface of lithium (Li) metal can be coated with mineral oil or hydrocarbon compounds to suppress the formation of oxide/nitride layers. However, when this method is applied to the thermal vacuum deposition of photoelectric devices, it is difficult to completely remove the organic materials such as mineral oil before use. If residual organic components volatilize, they may contaminate the device on which the lithium is deposited, causing various problems.

### DETAILED DESCRIPTION OF THE INVENTION

### TECHNICAL PROBLEM

The present invention aims to solve the aforementioned conventional problems by providing a lithium alloy for vacuum deposition and a method for manufacturing the same, which can suppress oxidation and nitridation on the surface without the use of organic materials such as mineral oil. Moreover, the lithium alloy allows only lithium to selectively evaporate upon heating, thereby forming a lithium thin film on the substrate. Additionally, the present invention provides a method for forming a lithium thin film for photoelectric devices using the lithium alloy for vacuum deposition, and a photoelectric device including the lithium thin film manufactured thereby. However, these objectives are merely exemplary and do not limit the scope of the present invention.

### TECHNICAL SOLUTION

According to one aspect of the present invention, a lithium alloy for vacuum deposition is provided.

The lithium alloy for vacuum deposition includes bismuth (Bi) in an amount exceeding 23 wt% and less than 91 wt%, with the balance consisting of lithium (Li) and other unavoidable impurities, and may include at least an Li3Bi phase and a lithium phase.

In one embodiment, the bismuth (Bi) may be in a range of 50 wt% to 70 wt%.

In one embodiment, the Li3Bi phase may be in a range of 10 wt% to 84 wt% of the total weight of the lithium alloy for vacuum deposition.

In one embodiment, the Li3Bi phase may be in a range of 39 wt% to 70 wt% of the total weight of the lithium alloy for vacuum deposition.

In one embodiment, the lithium alloy may selectively vaporize only lithium when melted in a vacuum atmosphere at a temperature above the melting point of lithium and below the melting point of the Li3Bi phase.

According to another aspect of the present invention, a method for manufacturing a lithium alloy for vacuum deposition is provided.

The method for manufacturing the lithium alloy for vacuum deposition may include (a) forming a molten solution comprising bismuth (Bi) in an amount exceeding 23 wt% and less than 91 wt%, with the balance consisting of lithium (Li) and other unavoidable impurities, and (b) maintaining the molten solution at a temperature sufficient to keep it in a completely liquid state, followed by quenching to cast the lithium alloy.

In one embodiment, the quenching may include pouring the molten solution into a mold maintained at a temperature of 25°C or lower for cooling.

In one embodiment, the bismuth (Bi) may be in a range of 50 wt% to 70 wt%.

In one embodiment, after step (b), step (c) may be further performed, which includes maintaining the lithium alloy manufactured in step (b) in an argon (Ar) gas atmosphere for a predetermined period.

In one embodiment, step (c) may be performed in a gas atmosphere chamber including a glove box.

According to another aspect of the present invention, a method for manufacturing a lithium thin film for photoelectric devices is provided.

The method for manufacturing the lithium thin film for photoelectric devices includes heating the lithium alloy for vacuum deposition in a vacuum chamber to selectively deposit lithium, thereby forming a lithium thin film on at least one surface of a substrate. The lithium alloy for vacuum deposition includes bismuth (Bi) in an amount exceeding 23 wt% and less than 91 wt%, with the balance consisting of lithium (Li) and other unavoidable impurities, and may include at least an Li3Bi phase and a lithium phase.

In one embodiment, the temperature for heating the lithium alloy for vacuum deposition in the step of forming the lithium thin film may be higher than the melting point of lithium and lower than the melting point of the Li3Bi phase.

In one embodiment, the temperature may be in the range of 200°C to 500°C.

In one embodiment, the temperature may be equal to or lower than the sublimation temperature of lithium.

In one embodiment, before forming the lithium thin film in the vacuum chamber, a pretreatment step of maintaining the lithium alloy for vacuum deposition in an argon (Ar) gas atmosphere for a predetermined period may be performed.

In one embodiment, the vacuum atmosphere may be maintained at a vacuum degree of 10⁻⁸ to 10⁻⁷ Torr.

According to another aspect of the present invention, a photoelectric device is provided.

The photoelectric device includes an anode and a cathode disposed opposite to each other on a substrate, a charge generation layer, an electron injection layer, and an electron transport layer formed between the anode and the cathode. At least one of the cathode, the charge generation layer, and the electron injection layer may include a lithium thin film formed by the method for manufacturing a lithium thin film for photoelectric devices.

In one embodiment, the photoelectric device may be selected from the group consisting of organic light-emitting diodes (OLEDs), solar cells, and transistors

### EFFECT OF THE INVENTION

According to the technical concept of the present invention, the use of the lithium alloy for vacuum deposition can suppress the formation of oxide or nitride films on the surface compared to pure lithium. Moreover, since there is no need for coating to prevent film formation as in the case of pure lithium, contamination of the device during the deposition process is prevented, thereby improving the performance of photoelectric devices containing the lithium thin film. Of course, these effects do not limit the scope of the present invention.

### BRIEF DESCRIPTION OF THE DRAWINGS

FIG. 1 is a binary phase diagram of lithium (Li) and bismuth (Bi).
FIG. 2 is a schematic diagram illustrating the process of forming a lithium thin film according to one embodiment of the present invention.
FIG. 3 is a cross-sectional view showing the laminated structure of an organic light-emitting diode (OLED) according to one embodiment of the present invention.
FIG. 4 is an XRD analysis result showing the composition of the lithium alloy manufactured according to the experimental example of the present invention.

### MODE FOR CARRYING OUT THE INVENTION

Hereinafter, various embodiments of the present invention will be described in detail with reference to the accompanying drawings. The embodiments of the present invention are provided to explain the present invention more completely to those skilled in the art, and the following embodiments may be modified in various forms, and the scope of the present invention is not limited to these embodiments. Rather, these embodiments are provided to faithfully and completely disclose the present invention and fully convey the concept of the invention to those skilled in the art. In addition, the thickness or size of each layer in the drawings may be exaggerated for clarity and convenience of explanation.

In the present invention, lithium (Li) is presented as an example of an alkali metal, and sodium (Na), potassium (K), rubidium (Rb), or cesium (Cs) may also be used instead of lithium (Li). However, lithium (Li) is exemplarily described.

Additionally, bismuth (Bi) is a low-melting-point metal with a melting point of 500°C or lower, and instead of bismuth (Bi), thallium (Tl), lead (Pb), bismuth (Bi), or polonium (Po) may be used. However, bismuth (Bi) is exemplarily described.

Hereinafter, a method for manufacturing a lithium alloy for vacuum deposition according to one embodiment of the present invention and the lithium alloy for vacuum deposition manufactured thereby will be described.

The method for manufacturing the lithium alloy for vacuum deposition according to an embodiment of the present invention includes the steps of (S 100) forming a molten solution comprising bismuth (Bi) in an amount exceeding 23 wt% and less than 91 wt%, with the balance consisting of lithium (Li) and other unavoidable impurities, and (S200) maintaining the molten solution at a temperature sufficient to keep it in a completely liquid state, followed by quenching to cast the lithium alloy.

In step (S 100), lithium and bismuth are placed in a crucible and heated and melted to prepare a molten solution. In the molten solution, bismuth may be included in an amount exceeding 23 wt% and less than 91 wt%, with the balance consisting of lithium and other unavoidable impurities. Preferably, the composition of bismuth may be in a range of 50 to 90 wt%, or in a range of 50 to 70 wt%.

If the amount of lithium is excessively high, the reactivity of lithium increases, causing stability issues, and it is not desirable from the perspective of environmental safety and commercialization. Conversely, if the amount of lithium is too low, the available material decreases due to oxidation, leading to limitations in continuous deposition time and shortened manufacturing time.

In order to prevent lithium from reacting with oxygen during the preparation process of the molten solution, the preparation of the molten solution may be performed in an inert atmosphere or a vacuum atmosphere.

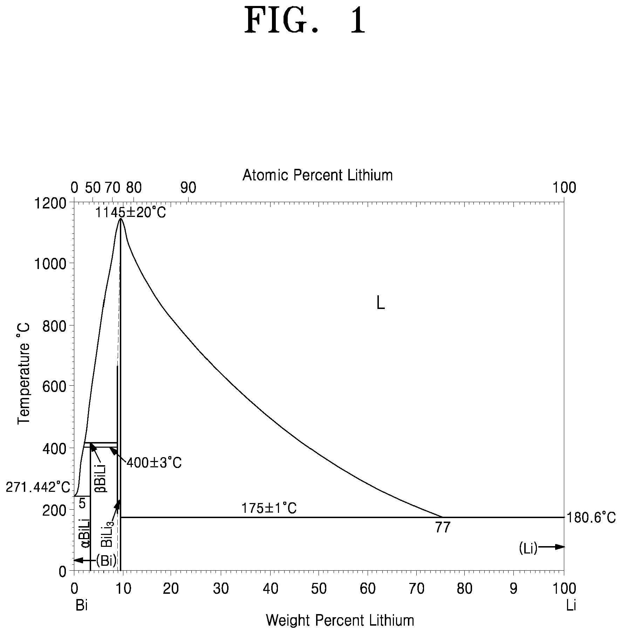

Bismuth (Bi) is an alloying element that can form intermetallic compounds with lithium (Li). FIG. 1 shows the phase diagram of the lithium-bismuth binary system.

Referring to FIG. 1, when bismuth is added in an amount exceeding 23 wt%, an intermetallic compound, Li3Bi phase, is formed. Li3Bi has a melting point of about 1,145°C, which is significantly higher than that of pure lithium or bismuth. To maintain the molten solution in a completely melted state within the crucible, the temperature must be kept higher than the melting point of Li3Bi.

In step (S200), the temperature of the molten solution is maintained at 1,145°C or higher, which is the condition where the Li3Bi phase is completely melted. The molten solution is then poured into a mold and cooled to cast the lithium alloy. During this cooling process, quenching may be included. Quenching may involve pouring the molten solution into a mold that is maintained at a temperature of 25°C or lower by a cooling medium. For example, the molten solution may be poured into a metal mold cooled by water at 10°C or lower to perform quenching.

When lithium (Li), which has a very low specific gravity of 0.534 g/cm³, is mixed and melted with bismuth (Bi), which has a relatively high specific gravity of 9.78 g/cm³, phase separation is highly likely to occur due to this difference in specific gravity. Therefore, in order to minimize such phase separation, it is desirable to apply a rapid solidification casting method. Moreover, this quenching process can induce miniaturizing of the Li3Bi phase formed in the lithium alloy, which allows uniform evaporation of lithium during the deposition process using the lithium alloy. Further details on this will be described later.

In the casting step, the upper limit of the temperature for maintaining the molten solution is preferably 1,200°C. If it exceeds 1,200°C, concerns arise regarding unnecessary energy cost increases and contamination from impurities in the crucible due to excessive temperatures.

During the casting step, the molten solution poured into the mold solidifies from liquid to solid phase, eventually being cast as a lithium-bismuth binary alloy.

The lithium alloy includes bismuth (Bi) in an amount exceeding 23 wt% and less than 91 wt%, with the balance consisting of lithium (Li) and other unavoidable impurities. In addition, the lithium alloy may include at least an Li3Bi phase and a lithium phase.

Referring to FIG. 1, when the molten solution is maintained at a temperature of 1,145°C or higher, which is the condition where the Li3Bi phase is completely melted, the final lithium alloy that has completed solidification has a microstructure in which at least the Li3Bi phase and the lithium phase coexist.

Table 1 below is calculated with reference to the phase diagram of FIG. 1, and shows the fraction (wt%) of the Li3Bi phase generated in the lithium alloy during the casting process, depending on the composition ratio of lithium (Li) and bismuth (Bi) in the molten solution.

**[Table 1]**

| Weight (wt%) | | Fraction in the Alloy (wt%) |
|---|---|---|
| Li | Bi | Li₃Bi |
| 77 | 23 | 0 |
| 70 | 30 | 10.3 |
| 60 | 40 | 25.0 |
| 50 | 50 | 39.8 |
| 40 | 60 | 54.5 |
| 30 | 70 | 69.2 |
| 20 | 80 | 83.9 |
| 9.1 | 90.9 | 100 |

Referring to FIG. 1 and Table 1, when the composition ratio of bismuth exceeds 23 wt%, the Li3Bi phase is formed. As the composition ratio of bismuth gradually increases, the fraction of the Li3Bi phase generated in the lithium alloy also increases. When it reaches 90.9 wt%, the Li3Bi phase constitutes 100% of the alloy. When the composition ratio of bismuth is greater than 23 wt% and less than 90.9 wt%, the composition ratio of lithium is greater than 9.1 wt% and less than 77 wt%. At this time, lithium is introduced in excess compared to the stoichiometric ratio required for forming the Li3Bi phase. Therefore, it can be said that the lithium alloy manufactured according to the composition ratio of the present invention contains at least a lithium phase and an Li3Bi phase.

Additionally, in one embodiment of the present invention, the lithium alloy may undergo a pretreatment step of being maintained in an inert atmosphere glove box for a predetermined time before being introduced into the vacuum deposition chamber for lithium thin film fabrication. The inert atmosphere includes an argon (Ar) atmosphere. For example, it can be pretreated by maintaining it in a glove box replaced with an argon atmosphere for 1 to 100 hours. During the argon atmosphere pretreatment step, cutting the lithium alloy into the desired shape or packaging it as a product can be performed simultaneously.

Typically, before mounting the lithium alloy inside the vacuum deposition chamber, it undergoes a preparation process where it is left exposed to the atmosphere for a certain period. For example, after removing the lithium alloy used for vacuum deposition from its packaging, it is loaded into a loader and then introduced into the vacuum deposition chamber. During this process, the lithium alloy may inevitably be exposed to the atmosphere with a humidity of 30% to 40% for a certain time. While exposed to the atmosphere, an oxide film or nitride film may form on the surface of the lithium alloy, which can deteriorate the deposition characteristics.

**In** contrast, when the lithium alloy undergoes the pretreatment process, the effects of oxidation or nitridation on the lithium alloy are minimized compared to a lithium alloy introduced directly into the vacuum deposition chamber without such pretreatment, thereby improving the deposition characteristics of lithium. Specifically, when the pretreatment is performed in an inert atmosphere as described above, even if the lithium alloy is exposed to the atmosphere during transfer and mounting into the vacuum deposition chamber after the pretreatment, an oxide film or nitride film is formed slowly at a low rate on the surface of the lithium alloy, and the thickness of the formed film can also be thin.

In one embodiment of the present invention, the lithium alloy for vacuum deposition is accommodated in the evaporation source container of the vacuum chamber during the deposition process, followed by heating and melting, where only lithium is selectively evaporated or sublimated. At this time, the heating temperature is set above the melting point of lithium and below the melting point of the Li3Bi phase. For example, the heating temperature of the lithium alloy may be in the range of 200°C to 500°C, and the vacuum degree may be in a high vacuum state of less than 5×10⁻⁸ torr. Lithium melts at approximately 180°C and begins to evaporate rapidly at higher temperatures.

Under the deposition conditions, lithium in the lithium alloy used as the evaporation source melts, but the Li3Bi phase does not evaporate because its melting point is as high as 1,145°C, and thus it remains in a solid state under these conditions. That is, the molten lithium alloy inside the evaporation source container is in a state where at least liquid lithium and the Li3Bi phase in solid form coexist within the liquid phase. Therefore, only the liquid lithium evaporates under a vacuum atmosphere, forming a lithium thin film on the substrate. Once the lithium in the lithium alloy is completely evaporated and consumed, the Li3Bi phase may remain as a residue in the evaporation source container.

Thus, although the lithium alloy of the present invention is a binary alloy of lithium and bismuth, it functions as an evaporation source for lithium that selectively evaporates lithium only.

As shown in the phase diagram of FIG. 1, when bismuth is added in an amount less than 23 wt%, the Li3Bi phase cannot be formed, and the effects of the present invention cannot be expected. On the other hand, referring to Table 1, as the amount of bismuth added exceeds 23 wt%, the amount of available lithium in the lithium alloy decreases, and if it is added at 90.9 wt% or more, 100% of the Li3Bi phase is formed, resulting in the absence of lithium available for deposition. Therefore, the amount of bismuth added should be more than 23 wt% and less than 90.9 wt%.

The lithium alloy for vacuum deposition according to one embodiment of the present invention includes an Li3Bi phase that has low reactivity with oxygen or nitrogen. Therefore, it has superior oxidation resistance and nitridation resistance compared to pure lithium, resulting in slower oxidation or nitridation rates and improved deposition efficiency. Additionally, the risk of explosion or ignition is reduced, eliminating the need to manufacture the deposition equipment in an explosion-proof manner, thereby reducing costs.

During the step of casting the lithium alloy, rapid quenching of the molten solution allows the Li3Bi phase in the lithium alloy to be minimized in size. When the Li3Bi phase in the lithium alloy is minimized in this manner, the evaporation of lithium during the deposition step becomes more uniform. As a result, the uniformity of the thickness of the lithium thin film deposited on the substrate can be improved.

When the lithium alloy is in a molten state inside the evaporation source container, the non-volatile Li3Bi phase exists within the liquid lithium. Therefore, if the Li3Bi phase is coarse and irregular, the evaporation of lithium from the liquid phase also becomes uneven. Generally, when the molten solution is rapidly quenched during the casting step, the phases generated during the solidification process are known to be minimized. Thus, in one embodiment of the present invention, the lithium alloy can induce more uniform lithium evaporation by minimizing the Li3Bi phase through rapid quenching during the casting process.

According to one embodiment of the present invention, a lithium thin film for photoelectric devices can be manufactured using the lithium alloy.

In the present invention, the lithium thin film refers to a thin film containing lithium, which may be a single metal thin film composed only of lithium, or a thin film formed by adding lithium to an organic material, or a thin film formed by mixing lithium with another metal.

For example, in the case of the charge generation layer (CGL) of the photoelectric device, a lithium thin film formed by adding lithium to an organic material may be formed, and in the case of the cathode layer, a lithium thin film may be formed by simultaneously thermally vacuum-depositing silver (Ag) and a lithium alloy.

Referring again to FIG. 2, the process of forming a lithium thin film for photoelectric devices according to one embodiment of the present invention is schematically described.

As shown in FIG. 2, the evaporation source container 12 accommodates the lithium alloy as the evaporation source 20, and the substrate is mounted on the substrate holder 11. Subsequently, the interior of the vacuum deposition chamber 10 is maintained in a vacuum state by using a vacuum pump (not shown). The degree of vacuum may range from 10⁻⁸ to 10⁻³ Torr, for example, 10⁻⁸ to 10⁻⁷ Torr. The substrate may have various layers already formed on one surface to implement the photoelectric effect for forming the photoelectric device.

The lithium alloy, which is the evaporation source 20 accommodated in the evaporation source container 12, is heated. Here, the heating temperature is higher than the melting point of lithium and lower than the melting point of the Li3Bi phase, which is 1,145°C. For example, it is heated to a temperature range of 200°C to 500°C.

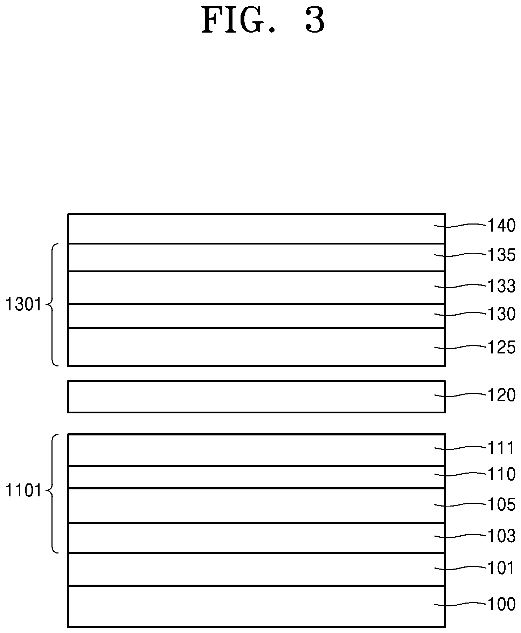

Since the melting point of the Li3Bi phase is higher than the heating temperature, it remains in a solid state, while lithium metal, with a melting point of 180.54°C, evaporates upon heating, flying in the direction of the substrate S inside the vacuum deposition chamber 10. Lithium is then deposited on the surface of the substrate S, forming the lithium thin film 30. The deposition rate is preferably selected within the range of 0.01 to 100Å/sec. FIG. 3 is a cross-sectional view illustrating the laminated structure of an organic light-emitting device according to one embodiment of the present invention.

As shown in FIG. 3, the light-emitting device according to an embodiment of the present invention includes an anode 101 and a cathode 140 facing each other on the substrate 100, and a first stack 1101, a charge generation layer (CGL) 120, and a second stack 1301 laminated between the anode 101 and the cathode 140.

Here, the cathode 140 may include the lithium thin film manufactured according to the embodiment of the present invention. Lithium has a low work function and can be used as a material to reduce the potential barrier formed at the interface of the cathode 140. When the lithium thin film is manufactured using the lithium alloy prepared according to the embodiment of the present invention, its reactivity is lowered, providing advantages in terms of processability and stability.

The first stack 210 is laminated with a hole injection layer 103, a first hole transport layer 105, a first light-emitting layer 110, and a first electron transport layer 111 in sequence between the anode 101 and the charge generation layer 120. The second stack 220 is laminated, in sequence, with a second hole transport layer 125, a second light-emitting layer 130, a second electron transport layer 133, and an electron injection layer (EIL) 135 between the charge generation layer 120 and the cathode 140. Additionally, an electron injection layer and a hole injection layer may further be provided below and above the charge generation layer 120, respectively.

The charge generation layer (CGL) 120 between the first stack 210 and the second stack 220 is formed between the stacks to control the charge balance between them. This charge generation layer 120 may be made of a material with low optical and electrical loss characteristics, and a lithium thin film manufactured according to the embodiment of the present invention can be used.

The first organic layer that the carriers injected from the cathode 140 encounter is the electron injection layer (EIL) 135, which facilitates smooth charge injection from the cathode 140 to the second electron transport layer 133. It is important for the electron injection layer 135 to reduce the potential barrier formed at the interface. For example, metal halide compounds such as lithium fluoride (LiF) are known to lower the potential barrier by forming an interface electric double layer with the organic layer, causing a shift in energy levels. Although lithium has high reactivity with oxygen or moisture and is challenging to use in practical electron injection layers, when a lithium thin film is manufactured using the lithium alloy prepared according to the embodiment of the present invention, its reactivity is lowered, allowing it to be used as a material for the electron injection layer 135.

Although the above description exemplifies an organic light-emitting device, according to another embodiment of the present invention, the lithium thin film can also be applied to inorganic light-emitting devices, solar cells, and transistors.

Hereinafter, specific experimental examples of the present invention will be presented. However, the embodiments described below are merely for illustrating or explaining the present invention in detail and are not intended to limit the scope of the present invention.

### <Experimental Example>

### 1. Experimental Example 1

Lithium and bismuth were alloyed in a weight ratio of 3:7 and exposed to the atmosphere. As shown in Table 2 below, in the case of the lithium alloy, the oxidation and nitridation films were formed more slowly and thinner under the same atmospheric exposure conditions compared to the use of pure lithium.

**[Table 2]**

| | Composition | Film Thickness (*µ*m) | | |
|---|---|---|---|---|
| | | 10 min exposure | 30 min exposure | 60 min exposure |
| Comparative Example 1 | Lithium (Li) | 150 | 220 | 280 |
| Experimental Example | Lithium-Bismuth | 30 | 50 | 70 |

### 2. Experimental Example 2

Lithium and lithium alloys were heated in a 5×10⁻⁸ Torr vacuum chamber to compare the sublimation temperature (or vaporization temperature). As shown in Table 3 below, the lithium-bismuth alloy exhibited the same sublimation temperature as that of pure lithium due to the low melting point of bismuth, compared to a multi-component lithium alloy (Zr-Al-Li).

**[Table 3]**

| | Composition | Sublimation Temperature **(°C)** |
|---|---|---|
| Comparative Example 1 | Lithium (Li) | 420 |
| Experimental Example | Lithium-Bismuth | 420 |
| Comparative Example 2 | Multi-component Lithium Alloy (Zr-Al-Li) | 950 |

### 3. Experimental Example 3

The lithium alloy was pretreated in glove boxes with argon and nitrogen atmospheres, respectively. Afterward, the alloy was taken out into the atmosphere, and the external appearance of the alloy was observed for 2 hours, which is summarized in Table 4.

**[Table 4]**

| | | Immediately After Exposure | After 1 Hour of Exposure | After 2 Hours of Exposure |
|---|---|---|---|---|
| Argon (Ar) | Experimental Example | Silver | Silver | Black with partial whitening |
| | Comparative Example 1 | Silver | Black with partial whitening | Fully whitened |
| | Comparative Example 2 | Black with partial whitening | Black with partial whitening | Black with partial whitening |
| Nitrogen (N₂) | Experimental Example | Silver | Black with partial whitening | Fully whitened |
| | Comparative Example 1 | Silver | Fully whitened | Fully whitened |
| | Comparative Example 2 | Black with partial whitening | Black with partial whitening | Black with partial whitening |

As described above, when the pretreatment was performed in an argon atmosphere, a clean silver surface of the lithium alloy with almost no nitridation could be obtained. Furthermore, it was confirmed that the lithium-bismuth alloy showed robustness against oxidation and nitridation even after 2 hours of atmospheric exposure.

### 4. Experimental Example 4

A molten solution was formed by mixing lithium and bismuth according to the composition ratios shown in Table 5 below. The molten solution was maintained at 1,200°C, the temperature condition at which the Li3Bi phase is completely dissolved, for 1 hour, and then rapidly cooled by pouring it into a metal mold with cooling water flowing at 3°C to 5°C to prepare specimen. The prepared specimen were pretreated in a glove box under an argon (Ar) gas atmosphere with moisture and oxygen content of less than 1 ppm.

After mounting the specimen in the vacuum deposition chamber, a vacuum of 10⁻⁸ Torr was maintained, and the surface of the specimen was preheated to a temperature of about 500°C to 550°C to remove the surface film. At this time, the oxide or nitride film formed on the surface of the specimen was removed in a gaseous form, reducing the vacuum level. When the film was completely removed, the vacuum level returned to its original state, and the thickness of the lithium thin film deposited on the substrate was measured using a thickness sensor mounted on the substrate. At this time, it was confirmed that the lithium thin film thickened in angstroms (Å) per second, and when the desired deposition rate was achieved, the actual deposition process began. The preheat-up time required until lithium deposition started is shown in Table 5 below.

Additionally, in order to check the compositional deviation according to the composition ratio of the cast specimen, the ratio of lithium (Li) and bismuth (Bi) components was measured using the ICP-OES (PerkinElmer, AVIO550) analysis method, and the deviation from the design composition was verified and summarized in Table 5.

**[Table 5]**

| | Li-Bi Compositi on ratio (wt%) | Composition Deviation (±%) | Pre Heat-up Time (hr) | Deposition Conditions | | Deposition Result (Target Thickness = 100%) | |
|---|---|---|---|---|---|---|---|
| | | | | Heating Temp (°C) | Time (hr) | Thickness (%) | Thickness Deviation (±%) |
| Example 1 | 70:30 | 10 | 15 | 420 | 3 | 250 | 20 |
| Example 2 | 60:40 | 8 | 13 | 420 | 3 | 200 | 15 |
| Example 3 | 50:50 | 4 | 10 | 420 | 3 | 180 | 8 |
| Example 4 | 40:60 | 3 | 8 | 420 | 3 | 140 | 7 |
| Example 5 | 30:70 | 2 | 5 | 420 | 3 | 100 | 5 |
| Example 6 | 20:80 | 2 | 4 | 420 | 3 | 50 | 3 |

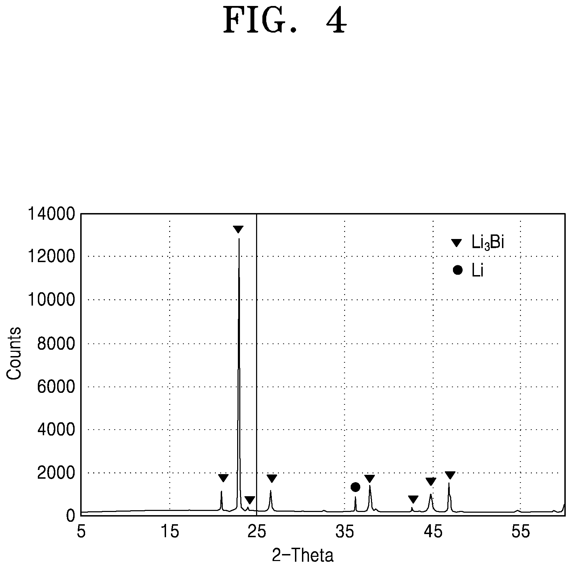

FIG. 4 shows the XRD analysis result of the specimen cast according to Example 3. It was used to confirm whether the Li3Bi phase was formed.

Referring to FIG. 4, when the content ratio of lithium (Li) to bismuth (Bi) is 50:50, it can be confirmed that the specimen is composed of Li3Bi and Li phases. Although there are differences in the intensity of the XRD peaks depending on the composition ratio, it was confirmed that all specimens were similarly composed of Li3Bi and Li phases.

Referring to Table 5, as in Examples 1 and 2, when the bismuth (Bi) content is relatively low at about 30 wt% to 40 wt%, the lithium content is relatively high, which provides the advantage of the deposited thickness being higher than the target thickness. However, the preheat time required to remove the oxide/nitride film was increased. This is because the intermetallic compound Li3Bi is relatively stable against oxidation and nitridation compared to pure lithium (Li), and surface oxidation and nitridation occur as the fraction of the Li3Bi phase generated decreases to about 10% to 25%.

On the other hand, as in Example 6, when the amount of bismuth (Bi) added is excessive at 80 wt%, the preheat time was short and the compositional deviation of the cast specimen was also small. However, since the fraction of the intermetallic compound Li3Bi generated is 83.9%, the amount of lithium (Li) that can actually vaporize is small, resulting in a lower deposition thickness under the same deposition conditions.

In the range where 50 to 70 wt% of bismuth (Bi) is added as in Examples 3 to 5, the compositional deviation of the cast lithium alloy was not significant, the preheat time for removing the film was appropriate, and the thickness deviation after deposition appeared uniformly within 10%.

According to the embodiment of the present invention configured as described above, when the composition and evaporation conditions of lithium and bismuth (Bi) are controlled and used as a thermal vacuum deposition material for photoelectric devices, the bismuth (Bi) component is not deposited and only lithium (Li) can be selectively deposited. Furthermore, the preheat time for removing the oxide and nitride films before deposition can be reduced, and lithium (Li) can be efficiently deposited without contamination from organic materials.

The present invention has been described with reference to the embodiments illustrated in the drawings, however, this is merely exemplary. It will be understood by those skilled in the art that various modifications and equivalent other embodiments may be derived therefrom. Accordingly, the true technical scope of protection of the present invention should be defined by the technical spirit of the appended claims.

## Claims

1. A lithium alloy for vacuum deposition, comprising: bismuth (Bi) in an amount of more than 23 wt% and less than 91 wt%; and the balance consisting of lithium (Li) and other unavoidable impurities, wherein the alloy includes at least a Li3Bi phase and a lithium phase.

2. The lithium alloy for vacuum deposition according to claim 1, wherein the bismuth (Bi) is in a range of 50 wt% to 70 wt%.

3. The lithium alloy for vacuum deposition according to claim 1, wherein the Li₃Bi phase is in a range of 10 wt% to 84 wt% based on the total weight of the lithium alloy for vacuum deposition.

4. The lithium alloy for vacuum deposition according to claim 3, wherein the Li₃Bi phase is in a range of 39 wt% to 70 wt% based on the total weight of the lithium alloy for vacuum deposition.

5. The lithium alloy for vacuum deposition according to claim 1, wherein the lithium alloy selectively vaporizes only lithium when melted in a vacuum atmosphere at a temperature above the melting point of lithium and below the melting point of the Li₃Bi phase.

6. A method for manufacturing a lithium alloy for vacuum deposition, comprising:
(a) forming a molten solution comprising bismuth (Bi) in an amount of more than 23 wt% and less than 91 wt%, with the balance consisting of lithium (Li) and other unavoidable impurities; and
(b) maintaining the molten solution at a temperature sufficient to keep it in a completely liquid state, followed by quenching to cast the lithium alloy.

7. The method for manufacturing a lithium alloy for vacuum deposition according to claim 6, wherein the quenching includes pouring the molten solution into a mold maintained at a temperature of 25°C or lower for cooling.

8. The method for manufacturing a lithium alloy for vacuum deposition according to claim 6, wherein the bismuth (Bi) is in a range of 50 wt% to 70 wt%.

9. The method for manufacturing a lithium alloy for vacuum deposition according to claim 6, further comprising, after step (b),
(c) a pretreatment step of maintaining the lithium alloy manufactured in step (b) in an argon (Ar) gas atmosphere for a predetermined period.

10. The method for manufacturing a lithium alloy for vacuum deposition according to claim 9, wherein step (c) is performed in a gas atmosphere chamber including a glove box.

11. A method for forming a lithium thin film for a photoelectric device, comprising: heating a lithium alloy for vacuum deposition in a vacuum chamber to selectively deposit lithium onto at least one surface of a substrate,
wherein the lithium alloy for vacuum deposition includes bismuth (Bi) in an amount of more than 23 wt% and less than 91 wt%, with the balance consisting of lithium (Li) and other unavoidable impurities, and includes at least an Li₃Bi phase and a lithium phase.

12. The method for forming a lithium thin film for a photoelectric device according to claim 11, wherein the temperature for heating the lithium alloy for vacuum deposition is higher than the melting point of lithium and lower than the melting point of the Li₃Bi phase.

13. The method for forming a lithium thin film for a photoelectric device according to claim 12, wherein the temperature is in the range of 200°C to 500°C.

14. The method for forming a lithium thin film for a photoelectric device according to claim 12, wherein the temperature is equal to or lower than the sublimation temperature of lithium.

15. The method for forming a lithium thin film for a photoelectric device according to claim 11, further comprising, prior to forming the lithium thin film in the vacuum chamber,
a pretreatment step of maintaining the lithium alloy for vacuum deposition in an argon (Ar) gas atmosphere for a predetermined period.

16. The method for forming a lithium thin film for a photoelectric device according to claim 11, wherein the vacuum atmosphere is maintained at a vacuum degree in the range of 10⁻⁸ to 10⁻⁷ Torr.

17. A photoelectric device, comprising: an anode and a cathode disposed on a substrate to face each other; and
a charge generation layer, an electron injection layer, and an electron transport layer formed between the anode and the cathode,
wherein at least one among the cathode, the charge generation layer, and the electron injection layer includes the lithium thin film formed by the method according to any one of claims 11 to 16.

18. The photoelectric device according to claim 17, wherein the photoelectric device is selected from the group consisting of an organic light-emitting diode (OLED), a solar cell, and a transistor.
